# EUROPÄISCHE PATENTSCHRIFT

(11) **EP 2 037 002 B1**
(45) Veröffentlichungstag und Bekanntmachung des Hinweises auf die Patenterteilung: **30.03.2011**
(21) Anmeldenummer: 08164119.3
(22) Anmeldetag: 11.09.2008
(51) Int. Cl.: C23C 16/44

(54) **Vorrichtung zur Abscheidung von Chalkogenen**
Device for separating chalkogens
Dispositif destinés à la séparation de chalcogènes

(30) Priorität: 11.09.2007 DE 102007043049
(43) Veröffentlichungstag der Anmeldung: 18.03.2009
(73) Patentinhaber: Centrotherm Photovoltaics AG, 89143 Blaubeuren (DE)
(72) Erfinder: Völk, Hans-Peter, 89608, Griesingen (DE); Hartung, Robert Michael, 89143, Blaubeuren (DE); Schmid, Dieter, 72764, Reutlingen (DE)
(74) Vertreter: Heyerhoff & Geiger

(56) Entgegenhaltungen:
- EP-A- 0 289 858
- EP-A- 1 531 189
- GB-A- 1 123 741
- US-A- 4 174 750
- US-A1- 2003 217 763
- US-A1- 2004 081 607
- US-A1- 2006 144 234

## Beschreibung

Die Erfindung betrifft eine Einrichtung zur Abscheidung von Chalkogenen, die während industrieller Prozesse in Prozessanlagen in gasförmigem Zustand anfallen.

Schwefel, Selen, Tellur sowie deren chemische Verbindungen untereinander oder mit anderen Stoffen, oder deren Gemische werden allgemein als Chalkogene bezeichnet und besitzen bei Raumtemperatur um 20 °C einen festen Aggregatzustand. Die Chalkogene können als Prozessstoffe zur Umsetzung/Umwandlung von metallischen Schichten, von so genannten Precursor-Schichten, z.B. auf Silizium oder Glasssubstraten, in eine Verbindungshalbleiter-Schicht eingesetzt werden.

Die Umsetzung bzw. Umwandlung der metallischen Precursor-Schichten, enthaltend Kupfer/Gallium und Indium, durch die Chalkogene in eine Verbindungshalbleiter-Schicht erfolgt üblicherweise bei hohen Temperaturen in einer Prozessanlage für thermische Prozesse, z.B. in einem Temper- oder Muffelofen. Typische Umsetzungs-/Umwandlungstemperaturen liegen bei 500°C-600°C. Die Umsetzungstemperatur ist dabei so hoch, dass die bei Raumtemperatur in festem Aggregat Zustand vorliegenden Chalkogene innerhalb der Prozessanlage einen dampfförmigen oder gasförmigem Aggregatzustand einnehmen.

Zur Umsetzung/Umwandlung der Precursor-Schicht in eine halbleitende Verbindungshalbleiter-Schicht wird allgemein Chalkogen im Überschuss benötigt. Ein Teil des dampfförmigen Chalkogens reagiert mit den Metallatomen der Precursor/Vorläufer-Schicht zu einer halbleitenden Verbindungshalbleiter-Schicht. Ein anderer Teil des Chalkogens wird im gasförmigen Zustand bzw. als Dampf, wie Selendampf, freigesetzt und muss aus der Prozessanlage einschließlich der Abgasanlagen bzw. den Rohrleitungen sowie aus den die Prozessanlage verlassenden Abgasen vollständig entfernt werden.

In Prozessanlagen zur Herstellung von halbleitenden Schichten aus Verbindungshalbleitern, die Kupfer, Gallium, Indium und Selen und/oder Schwefel enthalten, herrschen allgemein Temperaturen von 400°C bis 600°C. Bei diesen Temperaturen werden metallische Schichten, die Kupfer, Gallium und Indium enthalten können, zusammen mit Schwefel, Selen oder Tellur, deren chemische Verbindungen untereinander oder mit anderen Stoffen oder deren Gemischen, also dem Chalkogen, in halbleitende Schichten umgewandelt. Das Chalkogen nimmt bei den Prozessbedingungen, d.h. der vorgegebenen Temperatur und dem vorgegebenen Druck den gasförmigen Aggregatzustand ein und wird im Überschuss in die zur Umwandlung eingesetzte thermische Prozessanlage eingebracht.

Ein Teil des Chalkogens reagiert mit den metallischen Schichten zur halbleitenden Verbindungshalbleiter-Schicht. Ein anderer Teil des Chalkogens wird in der Prozessanlage freigesetzt und muss aus dieser entfernt werden. Typischerweise kondensiert das überschüssige Chalkogen, enthaltend Selen, Schwefel, Tellur und weitere Stoffe, in oder an kühleren Anlagenteilen - meist an unerwünschten Stellen -, bildet dort feste Ablagerungen, die im Rahmen von Wartungsarbeiten mühsam aus der Prozessanlage entfernt werden müssen.

Das Entfernen der Ablagerungen kann durch Öffnen der Prozessanlage und mechanisches oder chemisches Entfernen erfolgen. Das ist jedoch für industrielle Prozesse viel zu aufwändig und daher kein geeignetes Mittel zur Entfernung der Ablagerungen, zumal hierzu der Prozessablauf in der Prozessanlage jedes Mal unterbrochen werden muss.

Hohe Stillstandzeiten der Prozessanlagen sind die Folge. Bei den derzeit üblichen Anlagengrößen fallen pro Prozesstag typischerweise einige Kilogramm Schwefel, Selen und oder Tellur an. Hierbei handelt es sich um erhebliche Mengen an Ablagerungen, welche die Funktionsweise der Prozessanlage beeinträchtigen. Die Ablagerungen müssen daher während des laufenden Betriebs der Prozessanlage auf möglichst effektive Weise kontinuierlich aus dieser entfernt werden.

Bislang werden gekühlte Abscheidebleche zur definierten Ablagerung der überschüssigen Chalkogene in Prozessanlagen, wie Temperöfen, eingesetzt. Diese Abscheidebleche sind hier im Gasstrom angeordnet, also im aktiven Teil des Temperofens, und müssen von Zeit zu Zeit aus der Prozessanlage entfernt und durch gereinigte Abscheidebleche ersetzt werden. Problematisch sind dabei eine definierte Kühlung der Abscheidebleche, sowie ein einfacher und effektiver Austausch derselben zu Wartungszwecken. Die Wartung eines solchen Anlagenteils ist somit sehr zeitaufwändig und umständlich und führt zu längeren Stillstandszeiten. Abgesehen davon lassen sich hiermit die Chalkogene nicht vollständig aus den Abgasen entfernen.

Der Erfindung liegt nun die Aufgabe zugrunde, eine Einrichtung zur Abscheidung von Chalkogenen aus Abgasen von Prozessanlagen zu schaffen, derart dass eine vollständige, gefahrlose und sichere Entfernung der Chalkogene kontinuierlich während des laufenden Betriebs der Prozessanlage, auf möglichst effektive Weise ermöglicht wird.

Die mit einem Trägergas versetzten Prozessgase werden aus der Prozessanlage heraus über Anlagenkomponenten, wie Rohrleitungen, unter weitgehend isothermischen Bedingungen bei einer Temperatur oberhalb des Kondensationspunktes zu einer Einrichtung zur Abscheidung der Chalkogene durch Kondensation geleitet, in der zur Abscheidung der Chalkogene aus den Prozessgasen eine Temperatur unterhalb der Kondensationstemperatur aufrechterhalten wird.

Die Prozessabgase führenden Anlagenkomponenten werden dabei auf einer Temperatur zwischen 200 °C und 600 °C gefahren, d.h. je nach Ausführung der Anlage sind die bevorzugten Temperaturen 350 °C bei der Se-Beschichtung und 550 °C bei der Behandlung von Substraten mit Se-Dampf in einem Muffelofen. Dagegen wird die Temperatur in der Einrichtung zur Abscheidung der Chalkogene auf eine möglichst niedrige Temperatur unterhalb der Kondensationstemperatur der Chalkogene temperiert.

Bevorzugt wird die Temperatur in der Anlage zur Abscheidung der Chalkogene bei Raumtemperatur gehalten.

Die der Erfindung zugrunde liegende Aufgabe wird mit einer Einrichtung zur Abscheidung von Chalkogenen dadurch gelöst, dass die Prozessanlage über eine Rohrleitung mit einem Eingangsstutzen einer außerhalb derselben angeordneten Einrichtung zur Abscheidung von Chalkogenen verbunden ist, wobei die Rohrleitung und der Eingangsstutzen eine Wärmeverbindung zur Prozesskammer besitzen und/oder mit einer Heizeinrichtung versehen sind und wobei die mit einem Ausgangsstutzen sowie einem Gasauslass versehene Anlage zur Abscheidung der Chalkogene mit einer Kühleinrichtung ausgestattet ist, derart, dass der Eingangsstutzen von der Kühlung ausgenommen ist, dadurch gekennzeichnet, dass die Anlage zur Abscheidung von Chalkogenen mit einer internen Reinigungseinrichtung versehen ist.

In einer Ausgestaltung der Erfindung ist zwischen dem Eingangsstutzen und der Anlage zur Abscheidung der Chalkogene eine Thermoisolierung angeordnet.

Weiterhin können der Eingangstutzen und die Rohrleitung zur Prozessanlage mit einer Thermoisolierung versehen sein.

In einer Alternative können der Eingangsstutzen und die Rohrleitung zur Prozessanlage mit einer Heizeinrichtung in Form einer elektrischen Heizung versehen sein.

Um eine nachhaltige Kühlwirkung zu erreichen, kann die Anlage zur Abscheidung der Chalkogene mit einer Wasserkühlung ausgestattet werden.

Die Anlage zur Abscheidung von Chalkogenen weist ein zylinderförmiges Gehäuse zur Aufnahme der Reinigungseinrichtung auf, bei dem der Einlassstutzen oben und der Auslassstutzen unten am Gehäuse angeordnet sind.

In einer ersten Ausgestaltung sind in dem Gehäuse als Reinigungseinrichtung Bürsten und/oder Schaber angeordnet, die an einer Drehachse befestigt sind, welche in der Symmetrieachse des Zylinders liegt, wobei die Enden der Bürsten oder Schaber die Innenwand des Gehäuses berühren.

Die Bürsten und/oder Schaber sind bevorzugt ungekühlt, um unerwünschte Ablagerungen möglichst zu vermeiden.

Eine zweite Ausgestaltung ist **dadurch gekennzeichnet, dass** in dem zylinderförmigen Gehäuse eine Schnecke mit der Form einer archimedischen Schraube mit einer Schneidkante eingesetzt ist, deren Rotationsachse ebenfalls in der Symmetrieachse des Gehäuses liegt, wobei der Einlassstutzen oben an einem Ende der Schnecke und der Auslassstutzen unten am anderen Ende der Schnecke angeordnet ist, wobei die Schneidkante bis an die Innenwand des Gehäuses reicht.

Die Schnecke ist bevorzugt ungekühlt, um unerwünschte Ablagerungen möglichst zu vermeiden.

Die Symmetrieachsen der zylinderförmigen Gehäuse sind bevorzugt horizontal ausgerichtet.

Im Interesse einer ausreichenden Leichtgängigkeit sind die Bürsten und/oder Schaber oder die Schnecke mit geringfügigem Spiel im Gehäuse angeordnet.

Die zentrale Idee zur Lösung des Problems besteht in einer geeigneten Führung der Prozessgase mit den darin enthaltenen Chalkogenen bei genügend hohen Temperaturen zusammen mit einem Trägergas, das beispielsweise Stickstoff sein kann, innerhalb der Prozessanlage, z.B. einem Temperofen, bis zu einer definierten Einrichtung zu bringen, die sich auf einer definiert niedrigen Temperatur weit unterhalb der Kondensationstemperatur befindet. Wichtig ist dabei, dass sich sämtliche Gas führenden Anlagenteile auf genügend hoher Temperatur befinden, so dass sich innerhalb dieser Anlagenteile möglichst keine Chalkogene abscheiden/niederschlagen können.

Die auf definiert niedriger Temperatur gehaltene Einrichtung zur definierten Abscheidung von Selen, Schwefel, Tellur wird als Chalkogenfalle bezeichnet. Die Chalkogenfalle ist dabei Teil des Gas führenden Systems und befindet sich während des Betriebes des Temperofens ständig auf einer definiert niedrigen Temperatur. Damit bleiben die Gas führenden Teile der Anlage frei von unerwünschten Niederschlägen von Selen, Schwefel, Tellur usw. und die Wartungszyklen der Prozessanlage bzw. des Temperofens verlängern sich entsprechend. Damit ist die Produktivität eines mit einer solchen Chalkogenfalle ausgestatteten Temperofens deutlich höher als üblich.

Die Chalkogenfalle befindet sich nicht im aktiven Teil des Temperofens, sondern außerhalb desselben und wird ständig bei laufendem Betrieb durch eine entlang der Innenwand der Chalkogenfalle umlaufenden Bürste oder ein umlaufendes Messer von den Niederschlägen befreit, indem diese von der Innenwand abgelöst und in einem einfachen Sammelbehälter gesammelt, der von Zeit zu Zeit entsorgt werden muss, ohne den vor gelagerten Prozess zu stören.

Vorteile der vorliegenden Lösung des Problems liegen in extrem reduzierten Wartungsaufwand sowie der Vermeidung des Austausches von Maschinenteilen. Die Chalkogenfalle reinigt sich selbst mittels umlaufender Bürsten oder Messer, so dass das Entfernen von überschüssigem Chalkogen nicht zu Ausfallzeiten des Temperofens führt. Produktivität und verfügbare Betriebszeit (Uptime) eines Temperofens mit Chalkogenfalle sind deutlich höher als diejenigen vergleichbarer Anlagen mit herkömmlichen Kühlblechen.

Die Erfindung soll nachfolgend an einem Ausführungsbeispiel näher erläutert werden. In der zugehörigen Zeichnung zeigen:
- Fig. 1:: eine Chalkogenfalle mit umlaufenden Bürsten oder Messern zur Entfernung von Ablagerungen; und
- Fig. 2:: eine Chalkogenfalle mit einer Schnecke zur Entfernung von Ablagerungen.

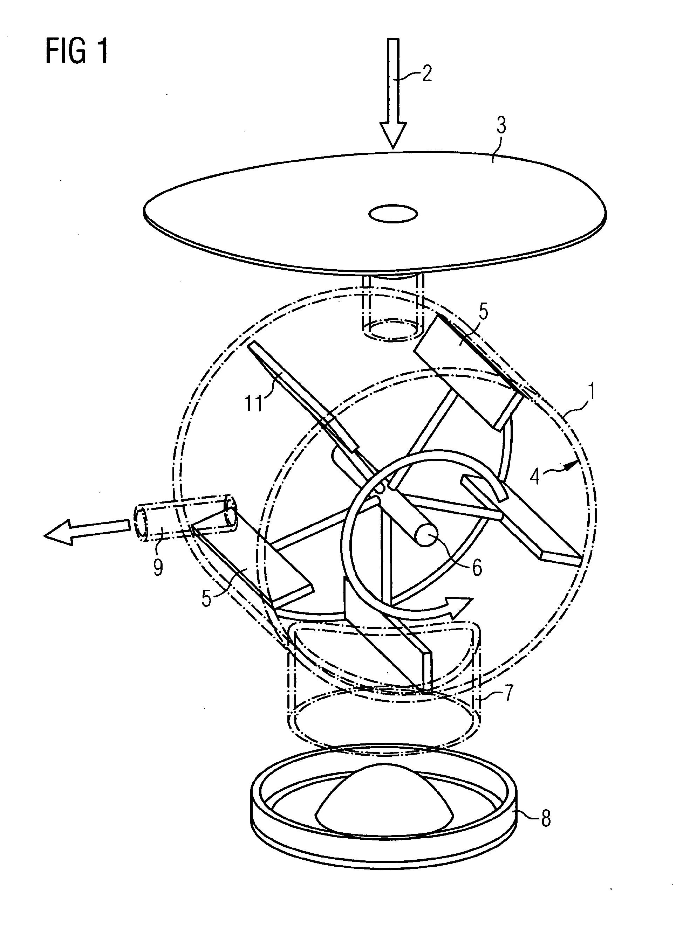

Die erfindungsgemäße Einrichtung zur Abscheidung von Chalkogenen, auch als Chalkogenfalle bezeichnet, besteht aus einem gekühlten Zylinder 1, der von Prozessgas 2, das aus einem nicht dargestellten Temperofen kommt, durchströmt wird (Fig. 1). Das Prozessgas 2 enthält dampfförmige Chalkogene sowie ein inertes Führungs- o der Trägergas. Ein solches inertes Trägergas kann Stickstoff sein. Bei der Zuführung des Chalkogendampf-/Trägergasgemisches muss darauf geachtet werden, dass dessen Temperatur bis zur Einleitung in den Zylinder 1 auf jeden Fall deutlich über der Verdampfungstemperatur der Chalkogene gehalten wird.

Der Zylinder 1 wird dagegen auf einer Temperatur gehalten, die deutlich unterhalb von 400°C liegt, z.B. bei Raumtemperatur um 20 °C. Der am Zylinder 1 befindliche Eingangsstutzen 3 wird jedoch auf einer hohen Temperatur über der Verdampfungstemperatur der Chalkogene gehalten, so dass hier keinerlei Kondensation von Schwefel und/oder Selen stattfinden kann. Sobald sich das Prozessgas 2 abkühlt, in dem es auf die gekühlten Wände 4 des Zylinders 1 der Chalkogenfalle trifft, wird es dort kondensieren bzw. sich dort ablagern.

Für die Entfernung der Ablagerungen an der gekühlten Wand 4 des Zylinders 1 sind im Zylinder umlaufende Bürsten oder Messer 5 mit Schneidkanten 11 vorgesehen, wobei sich die Rotationsachse 6 der Bürsten oder Messer 5 in der Symmetrieachse des Zylinders 1 befindet. Mit den Bürsten oder den Schneidkanten 11 der Messer 5 wird der Niederschlag an der Innenwand 4 des Zylinders 1, d.h. die kondensierten Chalkogene, sofort mechanisch entfernt. Das abgelöste Kondensat fällt daraufhin durch einen unteren Öffnungsstutzen 7 im Zylinder 1 in einen geeigneten über Schnellverschlüsse leicht austauschbaren Behälter 8. Die Bürsten oder Messer 5 sind nicht gekühlt, so dass unerwünschte Ablagerungen auf diesen weitgehend vermieden werden können.

Um eine ausreichende Leichtgängigkeit zu gewährleisten, sollten die Schneidkanten 11 der Messer auf einen minimalen Abstand zur Innenwand 4 eingestellt sein, so dass diese nicht oder nur leicht auf deren Oberfläche schleifen bzw. kratzen. Bei der Verwendung von ggf. zusätzlichen Bürsten können diese so eingestellt sein, dass diese auf der Wand 4 leicht schleifen.

Das nun von Chalkogen freie Prozessgas strömt durch einen in der Wand 4 befindlichen Abgasstutzen 9 aus dem Zylinder 1 in eine nicht dargestellte Abgasanlage heraus. Zur Verstärkung der Strömung kann im Abgasstutzen eine Lavaldüse eingesetzt werden. Die Kühlung des Zylinders 1 kann mittels Kühlwasser erfolgen, welches durch geeignete Kühlkanäle in oder auf der Außenwand des Zylinders zugeführt wird.

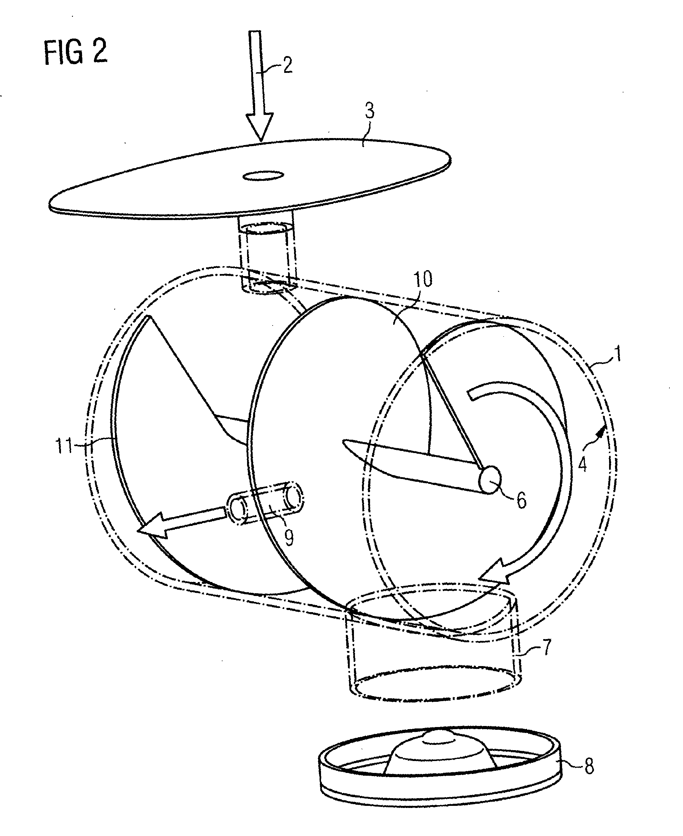

Eine weitere Ausführung der Erfindung ist in Fig. 2 dargestellt. Hierbei wird das umlaufende Messer oder die umlaufende Bürste durch eine Schnecke 10 mit der Form einer archimedischen Schraube ersetzt, deren Rotationsachse 6 ebenfalls in der Symmetrieachse des Zylinders liegt. Die Außenkante der Schnecke 10 dient hier als Schneidkante 11 und sollte daher leicht auf der Innenwand des Zylinders schleifen oder nur einen minimalen Abstand zur Innenwand aufweisen. Die Schnecke 10 ist ebenfalls ungekühlt, so dass unerwünschte Ablagerungen auf dieser möglichst vermieden werden können. Die Schneidkante entfernt das kondensierte Selen und/oder den kondensierten Schwefel von der Innenwand 4 des Zylinders 1 und fördert das entfernte Material zu einem unteren Öffnungsstutzen 7 im Zylinder 1, das daraufhin durch diesen in einen geeigneten Behälter 8 fällt.

Die zeichnerische Darstellung zeigt die Chalkogenfalle in Einbaulage, d.h. die heißen Anlagenteile (Eingangsstutzen) mit einer Temperatur deutlich oberhalb 400°C befinden sich zeichnungsgemäß oben. Die übrigen Anlagenteile (Zylinder 4 usw.) befinden sich zeichnungsgemäß darunter auf einer niedrigen Temperatur (z.B. Raumtemperatur).

### Bezugszeichenliste

- 1: Zylinder/Gehäuse
- 2: Prozessgas
- 3: Eingangsstutzen
- 4: Wand
- 5: Bürste oder Messer
- 6: Rotationsachse
- 7: Öffnungsstutzen
- 8: Behälter
- 9: Abgasstutzen
- 10: Schnecke
- 11: Schneidkante

## Patentansprüche

1. Einrichtung zur Abscheidung von Chalkogenen, die während industrieller Prozesse in Prozessanlagen in gasförmigem Zustand anfallen, bei welcher die Prozessanlage über eine Rohrleitung mit einem Eingangsstutzen (3) einer außerhalb derselben angeordneten Anlage zur Abscheidung von Chalkogenen verbunden ist, wobei die Rohrleitung und der Eingangsstutzen (3) eine Wärmeverbindung zur Prozesskammer und/oder eine Heizeinrichtung besitzen und wobei die mit einem Ausgangsstutzen sowie einem Gasauslass (9) versehene Anlage zur Abscheidung der Chalkogene mit einer Kühleinrichtung ausgestattet ist, derart, dass der Eingangsstutzen (3) von der Kühlung ausgenommen ist,
**dadurch gekennzeichnet,**
**dass** die Anlage zur Abscheidung von Chalkogenen mit einer internen Reinigungseinrichtung versehen ist.

2. Einrichtung nach Anspruch 1,
**dadurch gekennzeichnet ,**
**dass** zwischen dem Eingangsstutzen (3) und der Anlage zur Abscheidung der Chalkogene eine Thermoisolierung angeordnet ist.

3. Einrichtung nach Anspruch 1,
**dadurch gekennzeichnet ,**
**dass** der Eingangstutzen (3) und die Rohrleitung zur Prozessanlage mit einer Thermoisolierung versehen sind.

4. Einrichtung nach Anspruch 1,
**dadurch gekennzeichnet ,**
**dass** die Heizeinrichtung eine elektrische Heizung ist.

5. Einrichtung nach einem der Ansprüche 1 bis 3,
**dadurch gekennzeichnet ,**
**dass** die Anlage zur Abscheidung der Chalkogene mit einer Wasserkühlung versehen ist.

6. Einrichtung nach einem der vorangegangenen Ansprüche,
**dadurch gekennzeichnet ,**
**dass** die Anlage zur Abscheidung von Chalkogenen ein zylinderförmiges Gehäuse (1) zur Aufnahme der Reinigungseinrichtung aufweist, bei dem der Einlassstutzen (3) oben und der Auslassstutzen (7) unten am Gehäuse angeordnet sind.

7. Einrichtung nach Anspruch 6,
**dadurch gekennzeichnet ,**
**dass** in dem Gehäuse (1) als Reinigungseinrichtung Bürsten und/oder Schaber (5) angeordnet sind.

8. Einrichtung nach Anspruch 7,
**dadurch gekennzeichnet ,**
**dass** die Bürsten und/oder Schaber (5) an einer Drehachse (6) befestigt sind, die in der Symmetrieachse des Gehäuses (1) liegt, wobei die Enden der Bürsten oder Schaber (5) die Innenwand des Gehäuses (1) berühren.

9. Einrichtung nach Anspruch 8,
**dadurch gekennzeichnet ,**
**dass** die Bürsten und/oder Schaber (5) ungekühlt sind.

10. Einrichtung nach Anspruch 6,
**dadurch gekennzeichnet ,**
**dass** in dem zylinderförmigen Gehäuse (1) eine Schnecke (10) mit der Form einer archimedischen Schraube mit einer Schneidkante eingesetzt ist, deren Rotationsachse (6) ebenfalls in der Symmetrieachse des Gehäuses (1) liegt, wobei der Einlassstutzen (3) oben an einem Ende der Schnecke (10) und der Auslassstutzen (7) unten am anderen Ende der Schnecke (10) angeordnet ist und wobei die Schneidkante (11) bis an die Innenwand des Gehäuses (12) reicht.

11. Einrichtung nach Anspruch 10,
**dadurch gekennzeichnet,**
**dass** die Schnecke (10) ungekühlt ist.

12. Einrichtung nach Anspruch 7 oder 10,
**dadurch gekennzeichnet,**
**dass** die Bürsten und/oder Schaber (5) oder die Schnecke (10) mit geringfügigem Spiel im Gehäuse (1) angeordnet sind.

13. Einrichtung nach einem der Ansprüche 6 bis 11,
**dadurch gekennzeichnet,**
**dass** die Symmetrieachse zylinderförmigen Gehäuse (1) horizontal ausgerichtet ist.

## Claims

1. Device for the separation of chalcogens that occurs during industrial processes in process installations in the gaseous state, wherein the process installation is connected via a pipeline to an input connector (3) of an installation for separation of chalcogens arranged outside of it, in which the pipeline and the input connector (3) have a heat connection to the process chamber and/or a heating device and in which the installation for separation of chalcogens provided with an outlet connector as well as a gas outlet (9) is equipped with a cooling device so that the input connector (3) is excluded from cooling,
**characterized in that**
the installation for separation of chalcogens is provided with an internal cleaning device.

2. Device according to claim 1,
**characterized in that**
a heat insulation is arranged between the input connector (3) and the installations for separation of chalcogens.

3. Device according to claim 1,
**characterized in that**
the input connecter (3) and the pipeline to the process installation are provided with heat insulation.

4. Device according to claim 1,
**characterized in that**
the heating device is an electrical heater.

5. Device according to one of claims 1 to 3,
**characterized in that**
the installation of separation of chalcogens is provided with water cooling.

6. Device according to one of the preceding claims,
**characterized in that**
the installation for separation of chalcogens has a cylindrical housing (1) to accommodate the cleaning device, in which the input connector (3) is arranged on the top and the outlet connector (7) on the bottom of the housing.

7. Device according to claim 6,
**characterized in that**
brushes and/or scrapers (5) are arranged in the housing (1) as a cleaning device.

8. Device according to claim 7,
**characterized in that**
the brushes and/or scrapers (5) are fastened to an axis of rotation (6) lying in the axis of symmetry of the housing (1), the ends of the brushes or scrapers (5) touching the inside wall of the housing (1).

9. Device according to claim 8,
**characterized in that**
the brushes and/or scrapers (5) are uncooled.

10. Device according to claim 6,
**characterized in that**
a screw (10) with the shape of an Archimedes spiral with a cutting edge is inserted in the cylindrical housing (1), whose axis of rotation (6) also lies in the axis of symmetry of the housing (1), in which the inlet connector (3) is arranged on the top on one end of the screw (10) and the outlet connector (7) on the bottom on the other end of the screw (10) and in which the cutting edge (11) extends to the inside wall of the housing (12).

11. Device according to claim 10,
**characterized in that**
the screw (10) is uncooled.

12. Device according to claim 7 or 10,
**characterized in that**
the brushes and/or scrapers (5) or the screw (10) are arranged in the housing (1) with limited play.

13. Device according to claims 6 or 11,
**characterized in that**
the axis of symmetry of the cylindrical housings (1) is aligned horizontally.

## Revendications

1. Dispositif pour la séparation de chalcogènes qui sont produits à l'état gazeux pendant des processus industriels dans des installations de processus, dispositif pour lequel l'installation de processus est reliée par une tuyauterie à une tubulure d'entrée (3) d'une installation pour la séparation de chalcogènes placée à l'extérieur de celle-ci, la tuyauterie et la tubulure d'entrée (3) possédant une liaison thermique avec la chambre de processus et/ou un dispositif de chauffage et l'installation pour la séparation de chalcogènes, pourvue d'une tubulure de sortie ainsi que d'une évacuation de gaz (9), étant équipée d'un dispositif de refroidissement de telle manière que la tubulure d'entrée (3) est exclue du refroidissement,
**caractérisé en ce**
**que** l'installation pour la séparation de chalcogènes est pourvue d'un dispositif de nettoyage interne.

2. Dispositif selon la revendication 1,
**caractérisé en ce**
**qu'**une isolation thermique est placée entre la tubulure d'entrée (3) et l'installation pour la séparation de chalcogènes.

3. Dispositif selon la revendication 1,
**caractériseé en ce**
que la tubulure d'entrée (3) et la tuyauterie vers l'installation de processus sont équipées d'une isolation thermique.

4. Dispositif selon la revendication 1,
**caractérisé en ce**
**que** le dispositif de chauffage est un chauffage électrique.

5. Dispositif selon l'une des revendications 1 à 3,
**caractérisé en ce**
**que** l'installation pour la séparation de chalcogènes est pourvue d'un refroidissement l'eau.

6. Dispositif selon l'une des revendications précédentes,
**caractérisé en ce**
**que** l'installation pour la séparation de chalcogènes présente un bâti de forme cylindrique (1) pour recevoir le dispositif de nettoyage, bâti pour lequel la tubulure d'entrée (3) est placée en haut et la tubulure de sortie (7) est placée en bas sur le bâti.

7. Dispositif selon la revendication 6,
**caractérisé en ce**
**que** des brosses et/ou des racloirs (5) sont placés comme dispositif de nettoyage dans le bâti (1).

8. Dispositif selon la revendication 7,
**caractérisé en ce**
**que** les brosses et/ou racloirs (5) sont fixées à un axe de rotation (6) qui se situe dans l'axe de symétrie du bâti (1), les extrémités des brosses ou racloirs (5) touchant la paroi intérieure du bâti (1).

9. Dispositif selon la revendication 8,
**caractérisé en ce**
**que** les brosses et/ou racloirs (5) ne sont pas refroidis.

10. Dispositif selon la revendication 6,
**caractérisé en ce**
**qu'**une vis (10) avec la forme d'une vis d'Archimède avec une arête coupante est mise en place dans le bâti de forme cylindrique (1), vis dont l'axe de rotation (6) se situe également dans l'axe de symétrie du bâti (1), la tubulure d'entrée (3) étant placée en haut à une extrémité de la vis (10) et la tubulure de sortie (7) en bas à l'autre extrémité de la vis (10) et l'arête coupante (11) s'étendant jusqu'à la paroi intérieure du bâti (12).

11. Dispositif selon la revendication 10,
**caractérisé en ce**
**que** la vis (10) n'est pas refroidie.

12. Dispositif selon la revendication 7 ou 10,
**caractérisé en ce**
**que** les brosses et/ou racloirs (5) ou la vis (10) sont placés avec un léger jeu dans le bâti (1).

13. Dispositif selon l'une des revendications 6 à 11,
**caractérisé en ce**
**que** l'axe de symétrie du bâti de forme cylindrique (1) est orienté horizontalement.
